Europäisches Patentamt

(19) European Patent Office

Office européen des brevets

(11) Numéro de publication : **0 441 715 A1**

(12) **DEMANDE DE BREVET EUROPEEN**

(21) Numéro de dépôt : **91420002.7**

(22) Date de dépôt : **04.01.91**

(51) Int. Cl.⁵ : **H01L 39/14**

(30) Priorité : 05.01.90 FR 9000366

(43) Date de publication de la demande :
**14.08.91 Bulletin 91/33**

(84) Etats contractants désignés :
**BE DE GB IT SE**

(71) Demandeur : **MERLIN GERIN (Société Anonyme)**
**2, chemin des Sources**
**F-38240 Meylan (FR)**

(72) Inventeur : **Tournier, Robert**
**L'Archat**
**F-38850 Bilieu (FR)**
Inventeur : **Sulpice, André**
**22, Rue Edouard Vaillant**
**F-38100 Grenoble (FR)**
Inventeur : **Lejay, Pascal**
**71Bis, Cours Saint André**
**F-38800 Le Pont de Claix (FR)**
Inventeur : **Chaminade, Jean-Pierre**
**42, Rue la Fontaine**
**F-33400 Talence (FR)**

(74) Mandataire : **de Beaumont, Michel**
**1bis, rue Champollion**
**F-38000 Grenoble (FR)**

(54) **Elément de circuit électrique en matériau supraconducteur de Type 2.**

(57) La présente invention concerne un élément de circuit électrique en un matériau supraconducteur de type 2 à texture orientée, allongé dans une direction orthogonale à l'axe cristallographique c et muni de contacts à ses extrémités opposées, utilisé dans des conditions de champ et de température telles que son cycle d'aimantation est réversible, dans lequel les contacts (5, 6) sont formés dans un plan coupant l'élément de façon non orthogonale à l'axe c, et de préférence dans un plan parallèle à l'axe c et perpendiculaire à la direction générale du composant au niveau de ce contact.

Figure 4B

# ELEMENT DE CIRCUIT ELECTRIQUE EN MATERIAU SUPRACONDUCTEUR DE TYPE 2

La présente invention concerne le domaine de la réalisation de circuits électriques en matériau supraconducteur de type 2 qui seront les seuls supraconducteurs considérés ici.

A titre de référence générale sur la supraconductivité, on pourra se référer à l'ouvrage de A.C. Rose-Innes et E.H. Rhoderick intitulé "Introduction to superconductivity", 2ème édition, 1978, Pergamon Press. Dans sa deuxième partie, à partir du chapitre 12, cet ouvrage traite des supraconducteurs de type 2 présentant des champs critiques inférieur et supérieur HC1 et HC2. En présence d'un champ appliqué inférieur au champ critique HC1, ce champ appliqué étant ou bien un champ externe ou bien un champ résultant d'une circulation de courant dans un supraconducteur, ce supraconducteur se comporte comme un supraconducteur de type 1. Au dessus du champ critique HC1, on arrive à un état qualifié d'état mixte dans l'ouvrage ci-dessus référencé. Au delà du champ critique HC2 la supraconductivité disparaît.

Dans cet ouvrage, on s'intéresse notamment à l'une des propriétés importantes d'un supraconducteur, à savoir son courant critique. Il est exposé au chapitre 13 que, pour que le courant critique soit important, il faut que la caractéristique d'aimantation d'un supraconducteur de type 2 soit irréversible. On notera plus particulièrement en page 210 au troisième paragraphe le passage suivant :

"Dans le chapitre précédent on a vu que la présence de centres de piégeage donnait lieu à une aimantation irréversible pour des supraconducteurs de type II imparfaits. Si l'explication ci-dessus du courant critique est correcte, le courant critique dans l'état mixte doit être plus grand dans les matériaux qui présentent des courbes d'aimantation plus irréversibles. Ceci s'est avéré en fait être le cas."

Ainsi, pour décider de l'intérêt de l'utilisation d'un supraconducteur, il était classique de tracer sa courbe d'aimantation à la température souhaitée et l'on considérait que ce supraconducteur était intéressant, c'est-à-dire susceptible de laisser passer un courant critique élevé, dans le domaine où sa courbe d'aimantation était irréversible, c'est-à-dire où cette aimantation présentait un cycle d'hystérésis ouvert. Ceci apparaît notamment en figure 13.6 en page 210 du document cité où l'on compare le courant critique pour un matériau à cycle d'aimantation irréversible au courant critique pour un matériau à cycle d'aimantation réversible. Il ressort de la courbe b indiquant le courant critique en fonction de l'intensité du champ magnétique appliqué que ce courant critique devient négligeable entre les champs critiques inférieur et supérieur HC1 et HC2 quand le cycle d'aimantation devient réversible.

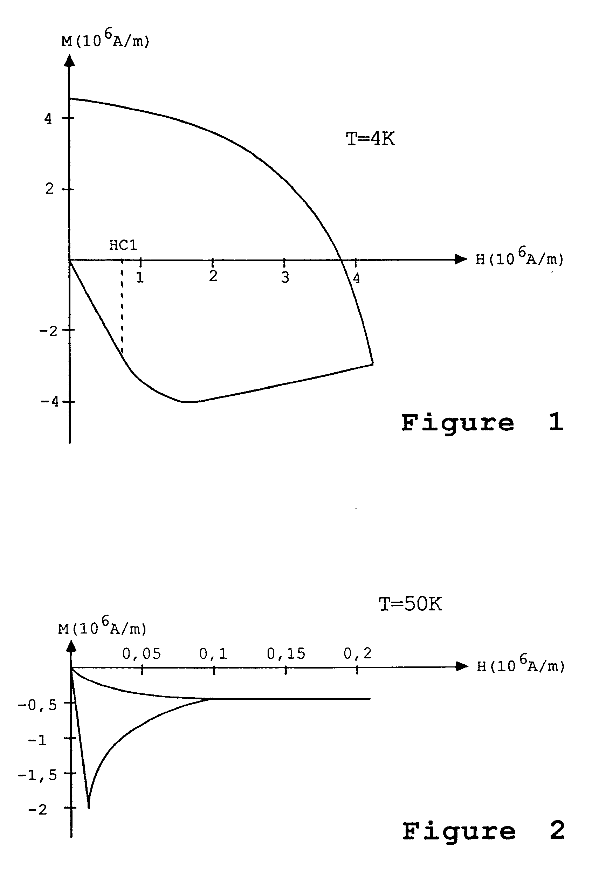

Une conséquence de cette théorie qui correspond à l'idée reçue actuelle dans le domaine des supraconducteurs est que les matériaux supraconducteurs peuvent en fait être utilisés seulement à des températures bien inférieures à leur température critique. En effet, pour des températures très inférieures à leur température critique, les supraconducteurs du type 2 présentent un cycle d'hystérésis ouvert, comme le représente le figure 1 qui correspond au cycle d'aimantation de matériaux des familles BiSr-CaCuO ou TIBaCaCuO à 4 K. Par contre, pour des températures plus élevées, le cycle d'aimantation devient sur sa plus grande partie réversible au-dessus d'un champ H* compris entre HC1 et HC2, comme le représente par exemple la figure 2 qui correspond au cycle d'aimantation des matériaux des familles susmentionnées à une température de 50 K. Ainsi, selon le critère classique ci-dessus énoncé, on considérait que, au-delà du champ H*, le supraconducteur présentait un courant critique pratiquement nul. En outre, comme l'indique d'ailleurs le passage cité, l'expérience semblait confirmer cette idée résultant des explications théoriques admises.

La présente invention, en se basant sur une analyse nouvelle des phénomènes apparaissant dans des supraconducteurs de type 2, propose un mode de connexion d'un supraconducteur permettant d'obtenir un courant critique élevé au-delà du champ H* à partir duquel le cycle d'aimantation devient réversible.

Ces caractéristiques et les avantages de la présente invention apparaîtront plus clairement à la lecture de la description ci-après faite en relation avec les figures jointes parmi lesquelles :

les figures 1 et 2 représentent des cycles d'aimantation d'un supraconducteur de type 2 à température très faible devant sa température critique et à une température plus proche de sa température critique ;

les figures 3A et 3B représentent en vue de dessus et en coupe le mode de connexion classique d'un élément supraconducteur en couche mince;

les figures 4A et 4B représentent en vue de dessus et en coupe le mode de connexion d'un supraconducteur selon la présente invention ;

la figure 5 représente la densité de courant critique dans un feuillet d'$YBa_2Cu_3O_{7-x}$ en fonction de l'inverse de l'épaisseur de ce feuillet ;

la figure 6A représente des cycles d'aimantation d'un matériau NbTi filamentaire supraconducteur pour des champs de 1 et 2 teslas, en fonction de la température ; et

la figure 6B représente, pour le matériau de la figure 6A, la densité de courant critique à 4,2 K en fonction du champ appliqué.

Les matériaux supraconducteurs de type 2 préparés sous forme de couches minces ou de cristaux se présentent généralement sous forme de plaquettes dont l'épaisseur suivant l'axe c est très faible et dont les dimensions dans les plans (a,b) sont grandes.

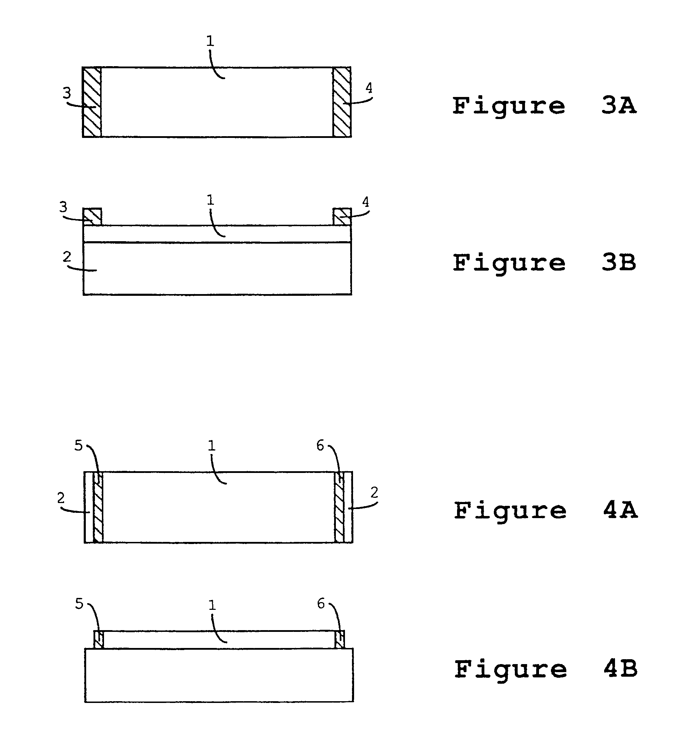

Les figures 3A et 3B illustrent le mode de connexion classique d'un supraconducteur 1 déposé en couche mince sur un substrat 2. L'axe c est perpendiculaire au plan de la couche mince. Les contacts 3 et 4 aux extrémités de la couche supraconductrice sont déposés sur la plus grande surface, c'est-à-dire parallèlement aux plans (a,b), comme cela résulte naturellement de la géométrie des matériaux préparés. Ceci correspond également au voeu d'obtenir une résistance de contact aussi faible que possible.

On notera que les cycles d'aimantation illustrés aux figures 1 et 2 correspondent à des champs appliqués selon l'axe c, c'est-à-dire orthogonalement au plan du supraconducteur 1.

Selon les théories développées et les expériences réalisées par le demandeur, le phénomène d'apparition de la réversibilité du cycle d'aimantation au-delà d'un champ H*, tel qu'illustré en figure 2 est un phénomène anisotrope. Le champ limite d'irréversibilité H* (qui varie avec la température) correspond à une véritable transition de phase qui marque l'apparition d'une structure supraconductrice feuilletée dans laquelle la couche supraconductrice 1 se divise en feuillets parallèles aux plans (a,b), ces feuillets étant alternativement supraconducteurs et à conductivité finie correspondant à l'état normal. On peut déduire de ce modèle l'apparition d'une résistance le long de l'axe c perpendiculaire aux feuillets dès que le champ H devient supérieur à H*. Par contre, si on applique un courant au supraconducteur dans une direction s'étendant dans le plan (a,b), le courant se transmettra dans les feuillets bien au-delà du champ critique H*.

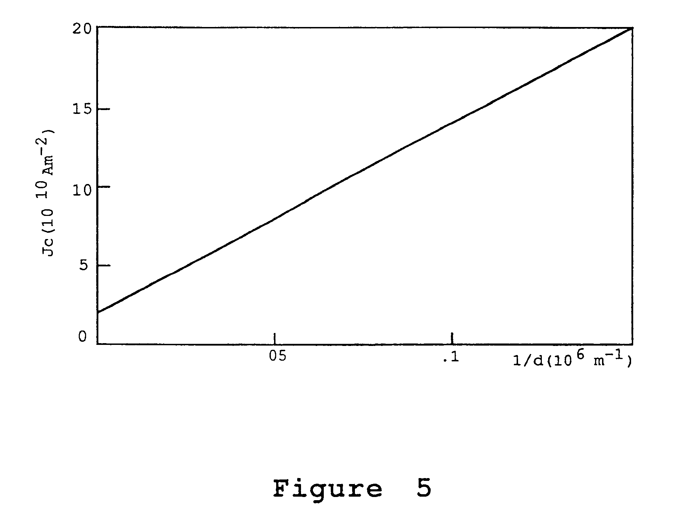

D'autre part, le demandeur a montré, dans le cas de cristaux de $YBa_2Cu_3O_7$, que la densité de courant critique croît quand l'épaisseur des cristaux diminue. Cette variation est inversement proportionnelle à l'épaisseur, comme le représente la figure 5. Il en résulte que plus le matériau devient feuilleté plus la densité de courant critique augmente pour atteindre le courant critique limite du supraconducteur. Ainsi, les matériaux supraconducteurs connus pour contenir, parallèlement aux plans (a,b), des intercroissances de feuillets de phase parasite (cette phase parasite étant à conductivité normale ou ayant une température critique faible) ou de la même phase mais avec beaucoup de désordre atomique vont contenir des liaisons supraconductrices faibles que le champ magnétique rendra facilement normales.

En conséquence, pour obtenir un courant critique élevé dans un supraconducteur de type 2 entre les champs critiques HC1 et HC2, le demandeur propose simplement, comme cela est illustré en figures 4A et 4B, étant donné une couche supraconductrice 1 déposée de la même façon que celle des figures 3A et 3B, de disposer des contacts 5 et 6 en bout, de façon que le courant puisse se propager dans tous les feuillets supraconducteurs formés.

Selon l'inventeur, si la théorie classique selon laquelle le courant critique devenait négligeable au-delà du champ d'irréversibilité H* semblait être vérifiée par les expériences faites antérieurement, c'est précisément parce que les contacts étaient réalisés comme cela est illustré en figures 3A et 3B, c'est-à-dire que le courant ne pouvait pénétrer que dans le feuillet supérieur d'une couche supraconductrice ou d'un cristal supraconducteur et non pas dans tous ses feuillets.

D'autre part, selon un aspect de l'invention, on notera que plus les feuillets sont minces et nombreux dans une couche donnée, plus le courant critique sera élevé.

Ainsi, la présente invention prévoit, d'une part, comme cela a été énoncé précédemment, de disposer convenablement les contacts aux extrémités d'un élément de circuit supraconducteur, de façon sensiblement transversable à la direction vers laquelle s'étend le supraconducteur à partir du contact et, d'autre part, de feuilleter autant que possible le long des plans (a,b) la structure critallographique.

Le feuilletage peut être effectué en associant en parallèle des feuilles de matériaux orientées suivant les plans (a,b) de la structure cristallographique, par exemple en utilisant des supers-réseaux de feuillets de $Bi_2Sr_2Ca_2Cu_3O_{10}$ d'épaisseur inférieur à 10 micromètres séparés par d'autres feuillets du composé $Bi_2Sr_3CuO_6$ ou $Bi_2Sr_2Ca_{2-x}Y_xCu_3O_{10+y}$ où Y peut être remplacé par une autre terre rare en concentration suffisante pour faire disparaitre la conductivité de ce feuillet.

On peut aussi utiliser la propriété qu'ont de nombreux matériaux déposés en couche mince de contenir des feuillets d'intercroissance de phases différentes dans la structure critallographique. Par exemple, $Bi_2Sr_2Ca_2Cu_3O_{10}$ dont la température critique est de l'ordre de 110 K contient toujours, dans des conditions non-stoechiométriques, des phases minoritaires telles que $Bi_2Sr_2CaCu_2O_8$ et $Bi_2Sr_2CuO_6$ qui ont des températures critiques plus basses. Ceci constitue également un aspect original de la présente invention car l'on considérait généralement dans l'art antérieur que l'existence de tels feuillets d'intercroissance était une source de liaisons faibles nuisibles à la supraconductivité.

Dans ce qui précède, et plus particulièrement en figures 4A et 4B, on a considéré de petits éléments de matériaux supraconducteurs. En pratique, l'élément supraconducteur auquel s'appliquera l'invention sera un composant d'un circuit électrique, par exemple une spire ou une ligne que l'on veut relier à d'autres composants du circuit.

La présente invention a été décrite essentiellement dans le cadre de supraconducteurs en couche mince. Elle s'appliquera également à des supraconducteurs monocristallins ou à texture orientée en forme de fils, de barreaux, ou autres.

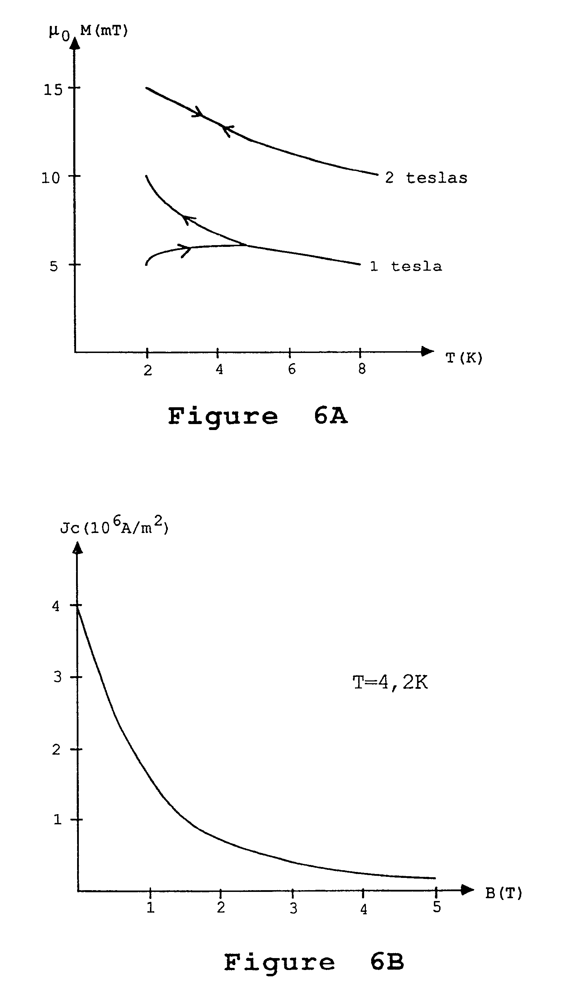

Pour vérifier les théories expliquant la présente invention, des expériences ont été faites par le demandeur sur un supraconducteur de type 2 tel que du NbTi multifilamentaire. Les résultats de ces expériences sont illustrés en figures 6A et 6B. La figure 6A représente des cycles d'aimantation pour des champs de 1 et 2 teslas, en fonction de la température entre 2 et 8 K. On voit que, dès que le champ atteint environ 2 T, le cycle d'aimantation devient réversible. La figure 6B représente, pour le matériau de la figure 6a, la densité de courant critique à 4,2°K en fonction du champ appliquée. A cette température, la courbe d'aimantation est réversible dès que le champ atteint environ 1 T et pourtant la densité de courant critique est loin d'être négligeable au-delà de cette valeur.

**Revendications**

1. Elément de circuit électrique en un matériau supraconducteur de type 2 à texture orientée, allongé dans une direction orthogonale à l'axe cristallographique c et muni de contacts à ses extrémités opposées, utilisé dans des conditions de champ et de température telles que son cycle d'aimantation est réversible, caractérisé en ce que lesdits contacts (5,6) sont formés dans un plan coupant ledit élément de façon non orthogonale à l'axe c.

2. Elément supraconducteur selon la revendication 1, caractérisé en ce que chaque contact est formé dans un plan parallèle à l'axe c et perpendiculaire à la direction générale du composant au niveau de ce contact.

3. Elémént supraconducteur selon la revendication 1, caractérisé en ce que la croissance est effectuée dans des conditions non-stoechiométriques de façon à favoriser la formation de feuillets d'intercroissance.

4. Elément de circuit électrique en un matériau supraconducteur de type 2 à texture orientée, formé par dépôt en couche mince sur un substrat, allongé dans une direction orthogonale à l'axe cristallographique c et muni de contacts à ses extrémités opposées, utilisé dans des conditions de champ et de température telles que son cycle d'aimantation est réversible, caractérisé en ce que lesdits contacts (5,6) sont formés dans un plan coupant la couche mince de façon non orthogonale à l'axe c.

5. Elément supraconducteur selon la revendication 4, caractérisé en ce que le dépôt est effectué sous forme de super-réseau en feuillets supraconducteurs et normaux alternés selon des plans (a,b) du matériau.

Figure 1

Figure 2

Figure 3A

Figure 3B

Figure 4A

Figure 4B

Figure 5

Figure 6A

Figure 6B

Office européen
des brevets

**RAPPORT DE RECHERCHE EUROPEENNE**

Numero de la demande

EP 91 42 0002

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | EP-A-0 292 436 (IBM)<br>* colonne 9, ligne 57 - colonne 10, ligne 15; lignes 49-52, revendications * | 1-5 | H 01 L 39/14 |
| X | EP-A-0 302 354 (SIEMENS)<br>* abrégé; page 2, colonne 2, ligne 37 - colonne 3, ligne 3; revendications * | 1-5 | |
| X | EP-A-0 280 308 (HITACHI)<br>* revendications * | 1,2,4 | |
| A | PROCEEDINGS OF THE IEEE vol. 77, no. 8, août 1989, pages 1124-1130, New York, US; K. TACHIKAWA et al.: "Potential Methods for the Fabrication of High-Tc Superconductors for Wires and Cables"<br>* page 1125, colonne 2 - page 1127 * | 3,5 | |
| A | LETTERS TO NATURE vol. 342, 2 novembre 1989, pages 55-57; R.B VAN DOVER et al.: "Critical currents near 10 6 A cm -2 at 77 K in neutron-irradiated single-crystal YBa2Cu3O7"<br>* abrégé * | 3,5 | **DOMAINES TECHNIQUES RECHERCHES (Int. Cl.5)**<br><br>H 01 L |

Le présent rapport a été établi pour toutes les revendications

| Lieu de la recherche | Date d'achèvement de la recherche | Examinateur |
|---|---|---|
| BERLIN | 28-03-1991 | JUHL A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)